Europäisches Patentamt

European Patent Office

Office européen des brevets

(11) Publication number:

**0 094 711**
**B1**

## (12) EUROPEAN PATENT SPECIFICATION

(45) Date of publication of patent specification: **01.10.86**

(21) Application number: **83200653.0**

(22) Date of filing: **06.05.83**

(51) Int. Cl.⁴: **C 23 C 18/54, H 01 L 21/288**

(54) **Method of manufacturing finely structured metal patterns on metal or semiconductor surfaces.**

(30) Priority: **14.05.82 NL 8202009**

(43) Date of publication of application:
**23.11.83 Bulletin 83/47**

(45) Publication of the grant of the patent:
**01.10.86 Bulletin 86/40**

(84) Designated Contracting States:
**DE FR GB IT**

(56) References cited:
**DE-A-2 649 738**
**GB-A-1 163 463**
**US-A-4 201 998**

**CHEMICAL ABSTRACTS, vol. 77, no. 8, 21st August 1972, page 393, no. 53916z, Columbus, Ohio, USA L.N. VOZMILOVA et al.: "Chemical deposition of gold on gallium arsenide from phosphoric acid solutions"**

(73) Proprietor: **N.V. Philips' Gloeilampenfabrieken**
**Groenewoudseweg 1**
**NL-5621 BA Eindhoven (NL)**

(72) Inventor: **Molenaar, Arian**
**c/o INT. OCTROOIBUREAU B.V. Prof. Holstlaan 6**
**NL-5656 Eindhoven (NL)**
Inventor: **Van den Beemt, Johannes Andreas**
**Clemens**
**c/o INT. OCTROOIBUREAU B.V. Prof. Holstlaan 6**
**NL-5656 Eindhoven (NL)**

(74) Representative: **Van Schaik, Johannes**
**Wilhelmus et al**
**INTERNATIONAAL OCTROOIBUREAU B.V. Prof.**
**Holstlaan 6**
**NL-5656 AA Eindhoven (NL)**

# Description

The invention relates to a method of manufacturing finely structured metal patterns in or on metal or semiconductor surfaces.

Metal patterns in or on metal or semiconductor surfaces have so far been manufactured by means of photoetching methods (for example, GB-PS 1,163,463). The so-called "dry-etching", i.e. sputter etching, or "ion-etching" are also frequently used. However, when fine structures are to be manufactured, these methods fail due to the associated loss of resolving power. This is caused *inter alia* by the undercutting occurring. An additional disadvantage of photo-lacquers is that during the metallization they also obtain a metal coating. The cured photo-lacquer must thus be removed with the metal layer deposited thereon ("lift-off" methods). This again involves loss of resolving power. Moreover, many substrate materials require a pretreatment with an alkalimetalhydroxide solution in order to obtain a good bonding of the metal pattern and a good contact junction. This treatment often takes place with strong alkalimetalhydroxide solutions at an elevated temperature and for long periods of time. Moreover, many electroless metal plate baths, for example, copper, gold and gold-copper alloy baths, which are used for making the patterns, are strongly alkaline and are used at elevated temperatures up to 80 to 90°C. The usual positive photosensitive lacquers, however, cannot withstand contact with strongly alkaline liquids very well. Negative photo-lacquers can withstand contact with alkaline liquids better, but they are less suitable for making finely structured patterns by means of the usual U.V. exposure methods.

The method of manufacturing metal patterns in or on the surface of a substrate consisting of a metal or a semiconductor compound by means of an electroless metal plating solution while using a metallization mask is characterized according to the invention in that first a uniform layer of a compound selected from $SiO_2$ and $Si_3N_4$ is deposited on the substrate surface from the vapour phase, and that the desired metallization mask pattern is manufactured herefrom by photo-etching the uniform layer, the masked substrate is contacted with the electroless plating solution, if necessary after the masked substrate has been contacted with a liquid which deposits noble metal nuclei on the substrate.

If desired, the deposited layer may be compacted by a temperature treatment.

By means of this method it is possible to manufacture very fine patterns ($\leqslant 2\ \mu m$) on metals and semiconductor compounds.

In the experiments which led to the invention, it was found that $Al_2O_2$, deposited on a susbtrate from the vapour phase, from which a mask was then manufactured by means of a photo-etching method was covered as rapidly with metal as the free substrate upon metallization after deposition of nuclei. So selectivity in using $Al_2O_3$ is entirely out of the question. It was surprising that the $SiO_2$ and $Si_3N_4$ used in the same manner showed an excellent selectivity in the metal deposition in contrast with the $Al_2O_3$: no nuclei were deposited on the mask material, either from the electroless metal plating solution, or from a noble metal nuclei-depositing solution. Which factors play a role in the metallization or non-metallization of the mask material has remained entirely obscure.

As compared with the usual organic photolacquers, $SiO_2$ and $Si_3N_4$ as mask materials can withstand the contact with concentrated alkalimetalhydroxide at elevated temperature much better than the usual organic photo-lacquers, and they can also withstand acid noble metal solutions (acidified, for example, with HCl, acetic acid) which are used for the deposition of nuclei, acid electroless nickel plating solutions and also the alkaline electroless metal plating solutions for depositing gold, copper and gold-copper alloys.

Alternative methods for the deposition of a noble metal on a GaAs substrate through a silicon dioxide mask are described in US 4201998 and DE 2649738, where a galvanic process is applied, making use of the sufficient conductivity of the GaAs material.

In Chemical Abstracts, Vol. 77, No. 53916z, a bath composition is described for the selective deposition of gold to provide ohmic contacts with GaAs through windows in a silicon dioxide protective film. However, this process acts by an exchange mechanism and only allows the deposition of a very thin gold layer.

When using the method in accordance with the invention, the masking surface is not provided with nuclei and remains free from metal deposits. Since no metal deposit takes place on the mask surface, anti-fogging agents need not be used. Moreover, no "lift-off" method need be used as a result of which loss of resolving power might occur. On the contrary, not removing the masking layer sometimes has the advantage of an extra protection against atmospheric attack. In other cases it may just be of advantage that the masking layer can be removed by etching without this attacking the metal layer.

It is to be noted that silicon dioxide is known as a masking and is frequently used in semiconductor technology. Until now, however, this has always been used in combination with non-selective vapour deposition methods. As is also the case in the preferred method in accordance with the invention, the $SiO_2$ is subjected to a temperature treatment at approximately $600°C \pm 20°C$ for 1/4—1 hour as a result of which increase of the density of the material is achieved.

Within the scope of the present invention, such a silicon dioxide mask may first be used as an etching mask for profiling the underlying substrate material and then as a mask for the selective metallization of the substrate surface.

An embodiment which is interesting within the scope of the present invention relates to

providing a pattern of lines of gold, copper, or a gold-copper alloy on a surface which consists of $p$-GaAs. It is essential that said surface should be cleaned prior to the metallization by means of a strongly alkaline liquid (for example, 20% by weight of KOH solution in water). An extra advantage of said metallization is that the resulting contacts on $p$-GaAs shown an ohmic behaviour. Readily bondable gold patterns can also be provided on $p$-AlGaAs surfaces by means of similar methods.

A few embodiments will now be described for illustrations of the invention.

Example 1

A $p$-GaAs wafer which had been made $p+$-conductive by means of diffusion of zinc, was provided with a 150 nm thick silicon dioxide ("Silox") layer on the $p$-GaAs surface by chemical vapour deposition from a mixture of $SiH_4$ and oxygen at a temperature of 400°C. The assembly was then heated at 625°C for 30 minutes and subsequently cooled to ambient temperature. A pattern of lines to obtain the desired Silox mask was then etched in the Silox layer by means of a commercially available photo-lacquer and an etching liquid consisting of 1 part by volume of $NH_4F$-HF solution and 3 parts of water. The $NH_4F$-HF solution was obtained by mixing 7 parts by volume of $NH_4F$ solution (200 g of $NH_4F$ and 300 g of water) and 1 part by volume of HF solution (49% in water).

A wedge-shaped groove of 4 μm width and 2 μm depth was etched in the GaAs by contact at 25°C with a solution consisting of 1 part by volume of $H_2O_2$ (30% by weight), 1 part by volume of ammonia solution (25% by weight) and 10 parts by volume of water.

The GaAs wafer with the Silox line pattern was kept immersed at 70°C for approximately 4 minutes in a solution of 20% by weight of potassium hydroxide in water. After rinsing for approximately $\frac{1}{2}$ minute in dionized water, the GaAs wafer was kept immersed in a solution which was prepared by dissolving 0.3 g of palladium chloride in 9 ml of concentrated hydrochloric acid solution and diluting with 9 ml of water. 864 ml of glacial acetic acid were added and then another 22.6 ml of hydrofluoric acid solution (40% by weight) as described by L.A. d'Asaro c.s. in J. Electrochem. Soc. *127*, Sep. 1980, *pp*, 1935—1939.

After rinsing in running deionized water for a few minutes, the GaAs wafer was kept immersed for $1\frac{1}{2}$ hours in a solution heated at 50°C and containing per litre:
0.04 mol. cupric sulphate
0.014 mol. potassium gold (I) cyanide
0.072 mol. tetra Na salt of ethylenediaminetetra-acetic acid
0.12 mol. sodium hydroxide
0.10 mol. formaldehyde.

The wedge-shaped groove was then filled entirely with a gold alloy containing approximately 1% by weight of Cu. No metal at all had deposited on the Silox. The gold alloy layer behaved as an ohmic contact and proved to be bondable. After a temperature treatment for 20 minutes at 325°C in an argon atmosphere, the contact resistance was $1.4 \times 10^{-5} \Omega/cm^2$, which may be said to be good in every respect, for example, for use in laser technology.

Similar results can be obtained by using $Si_3N_4$ as a mask instead of Silox. This is deposited on the GaAs surface from a gas flow containing ammonia, nitrogen and silane ($SiH_4$).

Example 2

In the manner described in Example 1, a $p$-GaAs wafer was provided with a Silox mask, the pattern being provided by chemical etching with the $NH_4F$ HF solution. The GaAs was not etched. After providing nuclei, also in the manner of Example 1, the GaAs wafer was metallized selectively by keeping the water immersed for 10 minutes in a solution which was heated at 92°C and contained per litre of solution in water:

30 g glycine
10 g sodium hypophosphite and
30 g nickel chloride.

Well-adhering nickel was deposited on the GaAs while the Silox mask was not metallized.

Example 3

A $p$-AlGaAs-wafer was provided with a Silox mask in the manner described in Example 1. After carrying out the pretreatments according to Example 1, metallization was carried out for 1 hour in a solution also as described in Example 1. A selective and well-adhering gold deposit was obtained according to the pattern.

Example 4

A gold pattern as obtained in the metallization of Example 1 was also manufactured on a metallic copper layer having thereon a Silox mask instead of on the $p$-GaAs. For that purpose the same electroless plating gold alloy solution was used.

**Claims**

1. A method of manufacturing metal patterns in or on the surface of a substrate consisting of a metal or a semiconductor compound by means of an electroless metalplating solution while using a metallization mask, characterized in that first a uniform layer of a compound selected from $SiO_2$ and $Si_3N_4$ is deposited on the substrate surface from the vapour phase and the desired metallization mask pattern is manufactured herefrom by photo-etching the uniform layer, the masked substrate is contacted with the electroless metalplating solution if necessary after the masked substrate has been contacted with a liquid which deposits noble metal nuclei on the substrate.

2. A method as claimed in Claim 1 for selectively providing metal patterns on the surface of a substrate consisting of a metal or a semiconductor compound, characterized in that after providing a mask pattern formed from $SiO_2$ or $Si_3N_4$ the substrate is first profiled by etching before the masked substrate is contacted with the electroless metal plating solution or with the liquid which deposits metal nuclei on the substrate, when such a liquid is used.

3. A method as claimed in Claim 1 or 2 of manufacturing metal patterns on the surface of a substrate consisting of GaAs or AlGaAs, characterized in that after a treatment with an alkalimetalhydroxide solution and after providing nuclei, Au or an Au-Cu alloy is deposited selectively on the substrate masked by means of $SiO_2$ or $Si_3N_4$ by means of an electroless plating solution.

4. A method as claimed in Claim 1, 2 or 3, characterized in that $SiO_2$ is provided on the substrate surface by means of chemical deposition from the vapour phase and the resulting layer is compacted by heating the substrate with the layer for a period of 1/4—1 hour at a temperature of 610°C±20°C.

**Patentansprüche**

1. Verfahren zur Herstellung von Metallmustern in oder auf der Oberfläche eines aus einem Metall oder einer Halbleiterverbindung bestehenden Substrates mittels einer stromlos wirkenden Metallisierungslösung unter Verwendung einer Metallisierungsmaske, dadurch gekennzeichnet, dass auf der Substratoberfläche zunächst über die Dampfphase eine einheitliche Schicht einer Verbindung, gewählt aus $SiO_2$ und $Si_3N_4$ aufgetragen wird und daraus mittels einer Photoätztechnik das gewünschte Metallisierungsmaskenmuster hergestellt wird, das maskierte Substrat mit der stromlos wirkenden Metallisierungslösung in Kontakt gebracht wird, nachdem das maskierte Substrat nötigenfalls mit einer Edelmetallbekeimungsflüssigkeit in Kontakt gebracht worden ist.

2. Verfahren nach Anspruch 1 zum selektiven Abringen von Metallmustern in der Oberfläche eines aus einem Metall oder aus einer Halbleiterverbindung bestehenden Substrats, dadurch gekennzeichnet, dass nach dem Anbringen des aus $SiO_2$ oder $Si_3N_4$ gebildeten Maskenmusters das Substrat zunächst durch Ätzen profiliert wird bevor das maskierte Substrat mit der stromlos wirkenden Metallisierungslösung oder mit der Bekeimungsflüssigkeit in Kontakt gebracht wird, falls eine derartige Flüssigkeit verwendet wird.

3. Verfahren nach Anspruch 1 oder 2 zum Herstellen von Metallmustern auf der Oberfläche eines aus GaAs oder AlGaAs bestehenden Substrates, dadurch gekennzeichnet, dass nach einem Behandlung mit einer Alkalihydroxidlösung und nach dem Anbringen von Keimen, auf selektive Weise auf dem mittels $SiO_2$ oder $Si_3N_4$ maskierten Substrat mittels einer stromlos wirkenden Lösung Au oder eine Au-Cu-Legierung angebracht wird.

4. Verfahren nach Anspruch 1, 2 oder 3, dadurch gekennzeichnet, dass auf der Substratoberfläche durch chemische Abscheidung aus der Dampfphase $SiO_2$ angebracht wird und die erhaltene Schicht dadurch verdichtet wird, dass das Substrat mit der Schicht während einer Zeit von 1/4—1 Stunde bei einer Temperatur von 610°C±20°C erhitzt wird.

**Revendications**

1. Procédé pour la réalisation de motifs métalliques dans ou sur la surface d'un substrat constitué par un métal ou un composé semiconducteur à l'aide d'une solution de métallisation sans courant avec utilisation d'un masque de métallisation, caractérisé en ce qu'une couche uniform en un composé choisi entre $SiO_2$ et $Si_3N_4$ est d'abord deposé sur la surface du substrat à partir de la phase de vapeur, et que la configuration constituant le masque de métallisation requis en est réalisée par photodécapage, le substrat masqué est mis en contact avec la solution de dépôt sans courant, au besoin après que le substrat masqué à été mis en contact avec le liquide susceptible de déposer des germes de métal précieux sur le substrat.

2. Procédé selon la revendication 1, pour l'application sélective de configurations métalliques dans la surface d'un substrate constitué par un métal ou un composé semiconducteur, caractérisé en ce qu'après l'application de la configuration de masquage à partir de $SiO_2$ ou de $Si_3N_4$, le substrat est d'abord profilé par décapage avant que le substrat masqué ne soit en contact avec la solution de méallisation sans courant ou avec le liquide déposant des germes méalliques sur le substrat, dans le cas d'utilisation d'un tel liquide.

3. Procédé selon la revendication 1 ou 2, pour la réalisation de configurations métalliques sur la surface d'un substrat constitué par du GaAs ou du AlGaAs, caractérisé en ce qu'après un traitement avec une solution d'hydroxyde de métal alcalin ou aprés application de germes, de l'or ou un alliage d'or et de cuivre est déposé sélectivement sur le substrat masqué à l'aide de $SiO_2$ ou de $Si_3N_4$ à l'aide d'une solution de métallisation sans courant.

4. Procédé selon la revendication 1, 2 ou 3, caractérisé en ce que du $SiO_2$ est appliqué sur la surface du substrat par dépôt chimique à partir de la phase de vapeur et la couche en résultante est rendue plus dense par chauffage du substrat avec la couche pendant une période comprise entre $\frac{1}{4}$—1 heure à une température de 610°C±20°C.